# EUROPEAN PATENT SPECIFICATION

(11) **EP 1 949 120 B1**
(45) Date of publication and mention of the grant of the patent: **11.05.2016**
(21) Application number: 06829062.6
(22) Date of filing: 16.11.2006
(51) Int. Cl.: G01R 31/28, G01R 27/26, G01J 5/34

(54) **METHOD FOR TESTING A PASSIVE INFRARED SENSOR**
METHODE ZUM TESTEN EINES PASSIVEN INFRAROTSENSORS
PROCEDE POUR LE CONTROLE DE CAPTEUR INFRAROUGE PASSIF

(30) Priority: 16.11.2005 WO PCT/EP2005/005601
(43) Date of publication of application: 30.07.2008
(73) Proprietor: Microsystems on Silicon (Pty) Ltd., 0040 Lynnwood Ridge (ZA)
(72) Inventor: SUNTKEN, Artur, Wilhelm, 0041 The Willows (ZA)
(74) Representative: von Kreisler Selting Werner - Partnerschaft von Patentanwälten und Rechtsanwälten mbB
(86) International application number: PCT/EP2006/010989
(87) International publication number: WO 2007/057179

(56) References cited:
- WO-A-2004/076991
- WO-A-2004/090570
- WO-A-2005/031375
- US-A- 6 114 861
- US-A1- 2004 178 344

## Description

The present invention relates to a method for testing a passive infrared sensor having two terminal pins.

Passive infrared sensors (PIR sensors) are basically known and used e.g. as motion detectors when a person approaches a location within the acquisition area of the PIR sensor. Another application of PIR sensors is for detecting gasses such as CO₂. Those sensors are useful e.g. in the automotive field. One problem with PIR sensors is testing their functionality within a reasonable period of time. This is the case due to the measurement of the noise produced by the PIR sensor and its sensitivity. Another problem with PIR sensors is that their terminal pins are not accessible from outside of a housing in which the PIR sensor element and circuitry are arranged. The sensor element which typically comprises a pyro ceramic element is too sensitive so that leading its terminal pins outside of the housing will cause disturbances on the operation of the element. Moreover, the circuitry of PIR sensors becomes more and more complicate if the PIR sensor is used for automatically switching on an electric load (like a lamp) when a person is approaching a building or the like and for automatically switching off the electric load with a certain delay after the person no longer is in the sensitivity space of the sensor.

Traditional test methods for PIR sensors include noise measurement and responsivity test. For the noise measurement, many sensors are populated onto a test-rack at a time and tested simultaneously for some minutes, while the next batch is prepared for testing. For the responsivity test, the units are individually tested with a pulsing infrared source. The testing requires a high amount of human involvement.

Traditional test methods on PIR sensors are time consuming and require specialized test equipment. Handling is mostly done by operators, which is always a source for errors. Traditional test methods do not allow for automation at acceptable cost. For example, if a PIR sensor with a sensitivity range of about 10 m and an on time of 5 min. is to be tested, the following time consuming procedure has to be performed: Connecting the sensor to the voltage supply. Waiting until it switches off the load. Generating a putsing infrared signal, which is equivalent to a detection distance of more than 10m. It is possible that the unit does not switch. Generating a pulsing infrared signal, which is equivalent to a detection distance of less than 10m. Now the unit must switch if it works correctly. Waiting 5 min. for the load to switch off. This verifies that the on time is correct.

Accordingly, there is a need in the state of the art to cut down the time and minimize the equipment efforts required for testing a passive infrared sensor.

This problem is solved by methods as defined in claim 1 or claim 2.

One common method for measuring capacitances is the charge transfer method as disclosed e.g. in WO-A-2005/031375.

Electrically, a passive infrared sensor (PIR sensor) behaves like a capacitance connected in parallel with a resistor. PIR sensors are provided with a rather high resistance in the GMΩ range. An example for testing a passive infrared sensor provides for a controlled charging of the PIR sensor by repeatedly applying individual known electric charges to one of the terminal pins with a predetermined frequency per time unit, so that current will flow through the PIR sensor charging its capacitance. The development of the voltage drop between the two terminal pins of the PIR sensor is measured so that the charging characteristic of the PIR sensor is known. This charging characteristic is thereafter compared to a predetermined charging characteristic, i.e. a predetermined voltage change. If the measured voltage change and the predetermined voltage change differs within a predetermined value or range which results from such a passive infrared sensor having its capacitance and resistance parameters within the allowable tolerances, the tested infrared sensor operates correctly. Otherwise failure of the passive infrared sensor can be determined.

In an alternative example, the capacitance of the PIR sensor first is charged so as to be discharged stepwisely, while measuring the discharge characteristic of the PIR sensor in order to compare to this discharge characteristic with a predetermined discharge characteristic expected for a PIR sensor meeting the required specification parameters.

By way of the above-identified two methods, the capacitance of the PIR sensor as well as one of its parasitic stray capacitances between ground potential and the terminal pin to which the charges are applied, can be determined. In order to determine the symmetry of the stray capacitances, the above-identified methods are applied successively to both of the terminal pins.

Accordingly, one aspect of the present invention there is provided a method for testing a passive infrared sensor, the sensor comprising a housing in which an infrared sensor element with two terminal pins and a circuitry connected to the terminal pins of the infrared sensor element are arranged, the method comprising the following steps:
a) repeatedly generating and applying individual known electric charges to one of the terminal pins with a predetermined frequency per time unit and measuring the change of the voltage between the two terminal pins,
b) repeatedly generating and applying substantially identical individual known electric charges to the other terminal pin with substantially the same frequency per time unit and measuring the change of the voltage between the two terminal pins,
c) comparing the voltages measured in steps a) and b), and
d) indicating failure of the passive infrared sensor if the two voltages differ from each other by more than a predetermined value.

As an alternative of this method, according to a further aspect of the present invention there is provided a method for testing the above-mentioned passive infrared sensor, comprising the following steps:
a) generating and applying a known electric charge to one of the terminal pins,
b) repeatedly removing individual known electric charges via the one terminal pin with a predetermined frequency per time unit and measuring the change of the voltage between the two terminal pins,
c) generating and applying substantially an identical electric charge to the other terminal pin,
d) repeatedly removing substantially identical known electric charges via the other terminal pin with substantially the same predetermined frequency per time unit and measuring the voltage between the two terminal pins,
e) comparing the developments of the voltages measured in steps b) and d), and
f) indicating failure of the passive infrared sensor if the two voltages differ from each other by more than a predetermined value.

According to the present invention, in all the methods referred to above, definite charge or discharge packets are generated and applied to the PIR sensor input or terminal pin or terminal pins. The method can be performed within the housing of the PIR sensor because generating and applying or removing the charges cannot be done from outside of the housing since the terminal pins of the PIR sensor element (i.e. the pyro ceramic) are not allowed to be accessible from outside. The voltage values can be provided at the signal output terminal of the housing of the PIR sensor and can be fed to a tester for evaluation. As an alternative, the comparison of the voltage values can be performed within the test circuitry of the circuitry of the sensor. The indication of failure can be performed in the signal output terminal or a specific terminal of the sensor housing or can be done in the external tester.

Due to the fact that the PIR sensor element behaves like a capacitor, the voltage increases or decreases with every charge or discharge packet applied. The resulting voltage is processed through a circuitry comprising e.g. an analogue-to-digital converter. The result can be made available on an output pin of the circuitry, e.g. as a serial bit stream. Both PIR sensor connections, i.e. both terminal pins of the PIR sensor can be tested this way: After completing these procedures, which takes typically less than a second, the circuitry connected to the PIR sensor element can return to the normal operating mode for measuring and evaluating the output voltage of the PIR sensor element resulting from infrared radiation acquired by the PIR sensor element.

By way of the above-identified self test modes the following parameters of the PIR sensor can be established:
1. Both PIR sensor terminal pins (inputs) are connected to the sensor element
2. The capacitance of the PIR sensor element
3. The symmetry of any stray capacitance, and
4. Excessive DC leaking on the PIR sensor terminal pins and from the terminal pins to other nodes.

Verifying these parameters is sufficient to conclude that the sensor operates within its specification.

The present invention will be described in more detail referring to the drawing in which
- Fig. 1: shows the circuitry of a PIR sensor element for normal operation and for performing self test modes,
- Fig. 2: shows the connection of the PIR sensor element for applying charge packets to one of the terminal pins for self test purposes, and
- Fig. 3: shows the connection of the PIR sensor element for applying charge packets to the other terminal pin.

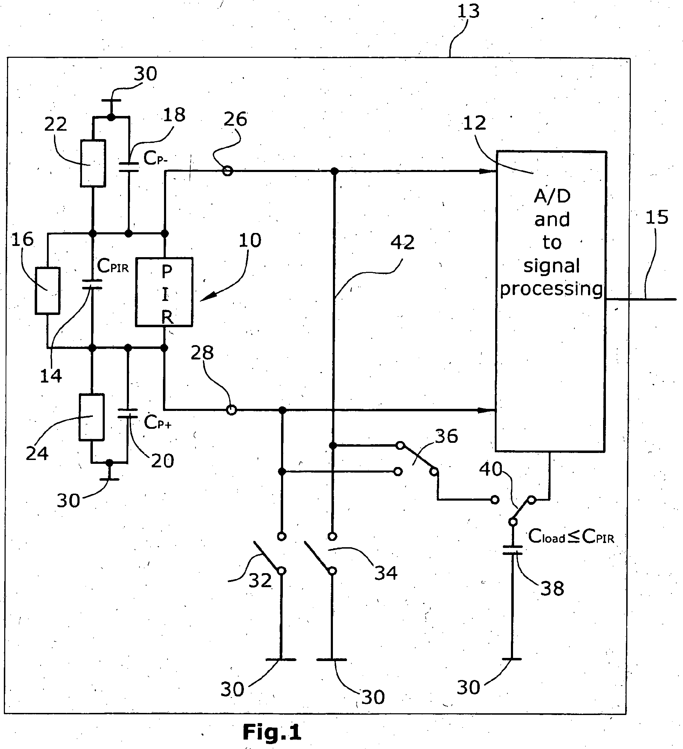

Fig. 1 shows a PIR sensor element 10 connected to a circuitry 12 for analogue-to-digital conversion of the analogue output signal of the PIR sensor element 10 and for signal processing. An example of the circuitry 12 is disclosed in WO-A-2004/090570 the disclosure thereof is incorporated herein by reference. It is pointed out that the present invention works well in particular in combination with the subject matter disclosed in WO-A-2004/090570.

In Fig. 1 also the electrical elements representing the PIR sensor element 10 are shown. Accordingly, the PIR sensor element 10 comprises.a capacitance C_{PIR} and a resistor 16 connected in parallel with each other. In addition stray capacitances Cₚ₋ and Cₚ₊ 18,20 as well as stray resistors 22,24 are arranged between each of the terminal pins 26,28. Each of these terminal pins can be connected to ground 30 by means of switches 32,34. These switches-32,34 as well as a further switch 36 and a charging capacitance C_{load} 38 with an associated switch 40 are used for self test purposes of the PIR sensor element 10 as will be explained hereinbelow.

For performing the self test, the normal operating mode of the PIR sensor and circuitry 12 as e.g. described in WO-A-2004/090570 is invoked after power-up for less than one second. The circuitry 12 also is designed for applying voltage to charge the capacitance 38 as well as for controlling the switches 32,34,36, and 40. The PIR sensor element 10 which comprises a pyro ceramic element, and the circuitry 12 are included in a housing 13 having terminals for the power supply (not shown) and at least one input and/or output terminal 15.

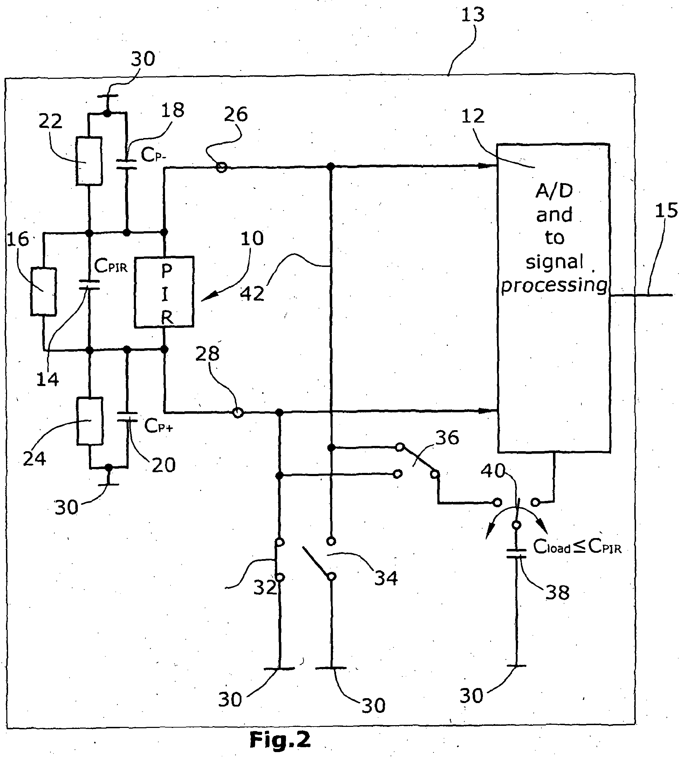

In a first phase of the self test, switches 32,34, and 36 are controlled so as to be transferred into the states shown in Fig. 2. While in the normal operating mode, both switches 32 and 34 are open, in a first phase of the self test mode one of these switches (in the instant embodiment, switch 32) is closed while the other one is still open. Switch 36 is operated so as to connect the capacitance 38 to line 42 within which the open switch 34 is connected. By repeatedly operating switch 40 between the loading state for charging the capacitance 38 and the discharging state for discharging the capacitance 38, individual charge packets are applied to terminal pin 26 of PIR sensor element 10, thus stepwisely charging the capacitance 14 of the PIR sensor element 10 and creating a flow of current from terminal pin 26 to terminal pin 28. In this embodiment, the voltage is measured by the circuitry 12. The voltage change represents the charging characteristic of the PIR sensor element 10, i.e. represents the combined capacitances 14 and 18 as well as the combined resistors 16 and 22. The voltage and, in particular, the extent of change of the voltage is compared with a predetermined development or value so as to verify whether the electric parameters of the PIR sensor element are within a predetermined range indicating correct operation of the PIR sensor element 10.

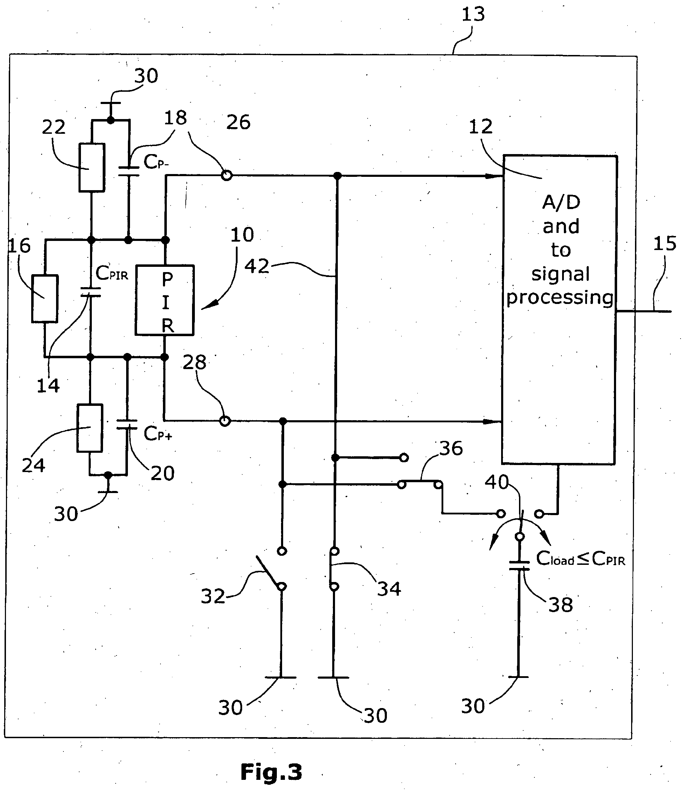

Thereafter, switches 32,34, and 36 are operated so as to be in the operating states as shown in Fig. 3. In this configuration, in a second phase, by switching switch 40 repeatedly between its two operating states, individual charge packets are applied to the other terminal pin 28 of the PIR sensor element 10 so as to measure the voltage across the PIR sensor element 10. The voltage change represents the combined capacitances 14 and 20 as well as the combined resistors 16 and 24. Prior to charging the PIR sensor element 10 in the second step as described in connection with Fig. 3, the PIR sensor element 10 should be discharged completely so that in both phases of the self test mode the same initial conditions are given. Again, the measured voltage is compared with a predetermined voltage change representing the desired electric behaviour of the PIR sensor element 10 so that failure of the PIR sensor element 10 can be detected as soon as the measured behaviour deviates for more than a predetermined range or value from the desired behaviour.

Also during each of the self test phases the same charging conditions are given. This means that, during each phase, the amount of the individual electric charges and the frequency of their application are the same.

Further, by comparing the voltages measured during the two phases of the self test mode, also the symmetry of the stray capacitances 18 and 20 can be detected. Finally, also excessive DC current leakage can be determined by the above-mentioned self test mode. Also one can determine whether or not the PIR sensor element terminal pins 26, 28 are connected to the PIR sensor element as such. Namely, in case of a disconnection, no voltage change will be created across the PIR sensor element 10 prior to a charging operation.

The measurement of the voltages generated across the PIR sensor element during the two phases of the self test mode is performed by the circuitry 12 which typically is provided with a signal processing unit performing all of the above-mentioned steps.

As being evident from the above, the sensor is housed in a package (with window) together with the infrared sensing element i.e. the pyro ceramic. The amount of pins accessible from outside of the housing has to be kept as low as possible. The reasons are cost and handling.

Because the sensor according to the invention is a complete product, assembled and sealed in one package, the access to the critical parameters is limited.

### Pyro Ceramic

The Pyro Ceramic is the infrared sensor element. It creates a current, which is proportional to the change in temperature. In one embodiment the sensor may behave electrically like a capacitor of approx 40pF, parallel connected to the current generated by the change in temperature. The change in voltage due to change in temperature may be some 100µV and depends on the capacitances and resistors of the sensor itself and around the sensor (parasitics). The change in temperature of the sensor itself e.g. can be below 10e-5 Kelvin for typical detection applications. The sensor element is electrically connected to the integrated circuit (IC) by means of 2 bond wires (terminal pins). Possible Faults are that the sensor element could be damaged or improperly connected or not be connected to the IC at all.

### Sensitivity and On time

These parameters could be pre-adjusted by internal voltage dividers. Possible faults are wrong voltages due to voltage dividers defect or not properly connected.

In the self test according to the invention, the sensor is switched to self test mode applying a voltage, which typically is out of normal range (ex. VDD + 0.3V) to the daylight sensor input. The IC generates a voltage ramp applied to the pyro element and digitizes the values. In addition, it measures the voltages applied to the programming pins for sensitivity and on time. The data is transmitted serially through the load switching output to a tester for evaluation.

If the voltage at the On time input is correct, then the behaviour of the sensor is On time correct.

If the voltage at the sensitivity input is correct, then the sensitivity range of the sensor is correct.

Voltages on both pyro sensor terminals within valid range
Pyro Ceramic is fault free
Connections are correct (no opens or shorts)
Leakage current on PCB and / or termination resistor of pyro ceramic
within specification.

The self test procedure can be completed within less than two seconds.

The detectors have to be very sensitive, because the change in temperature for detection is very small.

The sensor element consists of a pyro ceramic, which generates a current during temperature changes.

There have not been many PIR sensors in the market until now. They are very expensive, which may be due to the technology employed and the cost for testing. The invention offers the first solution, where the sensor contains only the sensor element and a silicon chip including the circuitry for normal operation and (self) testing of the sensor element No other components are required inside the package.

Although the invention has been described and illustrated with reference to specific illustrative embodiments thereof, it is not intended that the invention be limited to those illustrative embodiments. Those skilled in the art will recognize that variations and modifications can be made without departing from the true scope of the invention as defined by the claims that follow. It is therefore intended to include within the invention all such variations and modifications as fall within the scope of the appended claims and equivalents thereof.

## Claims

1. A method for testing a passive infrared sensor ,the sensor comprising a housing in which an infrared sensor element with first and second terminal pins and a H circuitry connected to the terminal pins of the infrared sensor element are arranged, the method comprising the following steps:
a) repeatedly generating and applying individual known electric charges to the first terminal pin (26,28) with a predetermined frequency per time unit for stepwisely charging a capacitance of the passive infrared sensor and measuring the voltage between the two terminal pins (26,28),
b) repeatedly generating and applying substantially identical individual known electric charges to the second pin (28,26) with substantially the same frequency per time unit and measuring the voltage between the two terminal pins (26,28),
c) comparing the voltages measured in steps a) and b), and
d) indicating failure of the passive infrared sensor (10) if the two voltages differ from each other by more than a predetermined value.

2. A method for testing a passive infrared sensor, the sensor comprising a housing in which an infrared sensor element with first and second terminal pins and a circuitry connected to the terminal pins of the infrared sensor element are arranged, the method comprising the following steps:
a) generating and applying a known electric charge to the first terminal pin (26,28),
b) repeatedly removing individual known electric charges via the first terminal pin (26,28) with a predetermined frequency per time unit for stepwisely discharging a capacitance of the passive infrarared sensor and measuring the voltage between the two terminal pins (26,28),
c) generating and applying substantially an identical electric charge to the second terminal pin (28,26),
d) repeatedly removing substantially identical known electric charges via the first terminal pin (28,26) with substantially the same predetermined frequency per time unit and measuring the voltage between the two terminal pins (26,28),
e) comparing the voltages measured in steps b) and d), and
f) indicating failure of the passive infrared sensor (10) if the two voltages differ from each other by more than a predetermined value.

3. The method according to claim 1 or 2, wherein failure of the passive infrared sensor (10) is indicated if the extents of change of the two measured voltages differ from each other by more than a predetermined value.

## Patentansprüche

1. Verfahren zum Testen eines passive Infrarotsensors, wobei der Sensor ein Gehäuse aufweist, in dem ein Infrarotsensorelement mit ersten und zweiten Anschlussstiften und eine mit den Anschlussstiften des Infrarotsensorelements verbundene Schaltung angeordnet sind, wobei das Verfahren folgende Schritte umfasst:
a) wiederholtes Erzeugen und Anlegen einzelner bekannter elektrischer Ladungen an den ersten Anschlussstift (26,28) mit einer vorbestimmten Frequenz pro Zeiteinheit zum schrittweisen Laden einer Kapazität des passiven Infrarotsensors, und Messen der Spannung zwischen den beiden Anschlussstiften (26,28),
b) wiederholtes Erzeugen und Anlegen im Wesentlichen identischer einzelner bekannter elektrischer Ladungen an den zweiten Anschlussstift (28,26) mit im Wesentlichen der gleichen Frequenz pro Zeiteinheit, und Messen der Spannung zwischen den beiden Anschlussstiften (26,28),
c) Vergleichen der in den Schritten a) und b) gemessenen Spannungen, und
d) Anzeigen eines Versagens des passiven Infrarotsensors (10), falls die beiden Spannungen um mehr als einen vorbestimmten Wert voneinander abweichen.

2. Verfahren zum Testen eines passive Infrarotsensors, wobei der Sensor ein Gehäuse aufweist, in dem ein Infrarotsensorelement mit ersten und zweiten Anschlussstiften und eine mit den Anschlussstiften des Infrarotsensorelements verbundene Schaltung angeordnet sind, wobei das Verfahren folgende Schritte umfasst:
a) Erzeugen und Anlegen einer bekannten elektrischen Ladung an den ersten Anschlussstift (26,28)
b) wiederholtes Abnehmen einzelner bekannter elektrischer Ladungen über den ersten Anschlussstift (26,28) mit einer vorbestimmten Frequenz pro Zeiteinheit zum schrittweisen Entladen einer Kapazität des passiven Infrarotsensors, und Messen der Spannung zwischen den beiden Anschlussstiften (26,28),
c) Erzeugen und Anlegen einer im Wesentlichen identischen elektrischen Ladung an den zweiten Anschlussstift (28,26),
d) wiederholtes Abnehmen im Wesentlichen identischer bekannter elektrischer Ladungen über den zweiten Anschlussstift (28,26) mit im Wesentlichen der gleichen vorbestimmten Frequenz pro Zeiteinheit, und Messen der Spannung zwischen den beiden Anschlussstiften (26,28),
e) Vergleichen der in den Schritten b) und d) gemessenen Spannungen, und
f) Anzeigen eines Versagens des passiven Infrarotsensors (10), falls die beiden Spannungen um mehr als einen vorbestimmten Wert voneinander abweichen.

3. Verfahren nach Anspruch 1 oder 2, bei dem ein Versagen des passiven Infrarotsensors (10) angezeigt wird, falls die Ausmaße der Veränderungen der beiden gemessenen Spannungen um mehr als einen vorbestimmten Wert voneinander abweichen.

## Revendications

1. Procédé pour tester un capteur à infrarouges passif, le capteur comprenant un boîtier dans lequel un élément de capteur à infrarouges avec des première et deuxième broches de borne et des circuits connectés aux broches de borne de l'élément de capteur à infrarouges sont disposés, le procédé comprenant les étapes suivantes :
a) la génération et l'application de façon répétée de charges électriques connues individuelles à la première broche de borne (26, 28) avec une fréquence prédéterminée par unité de temps pour charger par pas une capacité du capteur à infrarouges passif et la mesure de la tension entre les deux broches de borne (26, 28),
b) la génération et l'application de façon répétée de charges électriques connues individuelles sensiblement identiques à la deuxième broche (28, 26) avec sensiblement la même fréquence par unité de temps et la mesure de la tension entre les deux broches de borne (26, 28),
c) la comparaison des tensions mesurées dans les étapes a) et b), et
d) l'indication d'une défaillance du capteur à infrarouges passif (10) si les deux tensions diffèrent l'une de l'autre de plus d'une valeur prédéterminée.

2. Procédé pour tester un capteur à infrarouges passif, le capteur comprenant un boîtier dans lequel un élément de capteur à infrarouges avec des première et deuxième broches de borne et des circuits connectés aux broches de borne de l'élément de capteur à infrarouges sont disposés, le procédé comprenant les étapes suivantes :
a) la génération et l'application d'une charge électrique connue à la première broche de borne (26, 28),
b) le retrait de façon répétée de charges électriques connues individuelles par l'intermédiaire de la première broche de borne (26, 28) avec une fréquence prédéterminée par unité de temps pour décharger par pas une capacité du capteur à infrarouges passif et la mesure de la tension entre les deux broches de borne (26, 28),
c) la génération et l'application d'une charge électrique sensiblement identique à la deuxième broche de borne (28, 26),
d) le retrait de façon répétée de charges électriques connues sensiblement identiques par l'intermédiaire de la deuxième broche de borne (28, 26) avec sensiblement la même fréquence prédéterminée par unité de temps et la mesure de la tension entre les deux broches de borne (26, 28),
e) la comparaison des tensions mesurées dans les étapes b) et d), et
f) l'indication d'une défaillance du capteur à infrarouges passif (10) si les deux tensions diffèrent l'une de l'autre de plus d'une valeur prédéterminée.

3. Procédé selon la revendication 1 ou 2, dans lequel une défaillance du capteur à infrarouges passif (10) est indiquée si les ampleurs de changement des deux tensions mesurées diffèrent l'une de l'autre de plus d'une valeur prédéterminée.
